# EUROPEAN PATENT APPLICATION

(11) **EP 0 537 749 A1**
(43) Date of publication of application: **21.04.1993**
(21) Application number: 92117645.9
(22) Date of filing: 15.10.1992
(51) Int. Cl.: H01L 21/90

(54) **Method of manufacturing electrical interconnections in semiconductor devices**

(30) Priority: 16.10.1991 JP 267415/91
(71) Applicant: NEC CORPORATION, Tokyo (JP)
(72) Inventor: Ueno, Hisashi, Minato-ku, Tokyo (JP)
(74) Representative: Glawe, Delfs, Moll & Partner

(57) **Abstract**

Openings for contact holes, grooves, and through-holes are (38,39) formed in an insulating BPSG film (37) formed on a semiconductor substrate (36) including electrical circuit elements. Next, a conductive material (41) such as Al alloy is deposited over the entire substrate by sputtering technique, and then the insulating film is selectively removed from the substrate except for the regions at and near the openings.Thereafter, the Al alloy is caused to re -flow into the corresponding openings by means of laser light to form desired lead lines (30,31,33) in the openings (38,39).

## Description

### FIELD OF THE INVENTION

The invention relates to a method of manufacturing semiconductor devices, and in particular to a method of forming lead wires in such devices.

### BACKGROUND OF THE INVENTION

A typical conventional method of forming lead wires in semiconductor devices employs procedures as illustrated in Figs. 1 through 7 showing cross sections of a semiconductor substrate to be fabricated.

The first step of the procedures is to form in a semiconductor substrate 11 a local region 12 where impurities are diffused (which region will be hereinafter referred to as diffusion layer). Formed over the substrate is an insulating film 13 of boro-phospho-silicate glass (BPSG) (Fig. 1). A contact hole 14 is then formed in the BPSG layer (Fig. 2). The resultant substrate is then covered with an Al-Si-Cu film 15 formed through sputtering technique (Fig. 3). This film is etched so as to provide a first-layer lead lines 16 at specified regions (Fig. 4). In order to make the surface of the substrate flat, spin on glass (SOG) 18 is coated (Fig. 5) over the entire surface of the substrate after a CVD oxide layer 17 is formed over the substrate by CVD method. Over the SOG 18, a further layer of silicon oxide (referred to as plasma oxide layer) 19 is formed (Fig. 6) by plasma CVD method. After forming through-holes 20 at specified locations, the entire surface of the substrate is covered with a further Al-Si-Cu film 21, forming second-layer lead lines in the through-holes (Fig. 7).

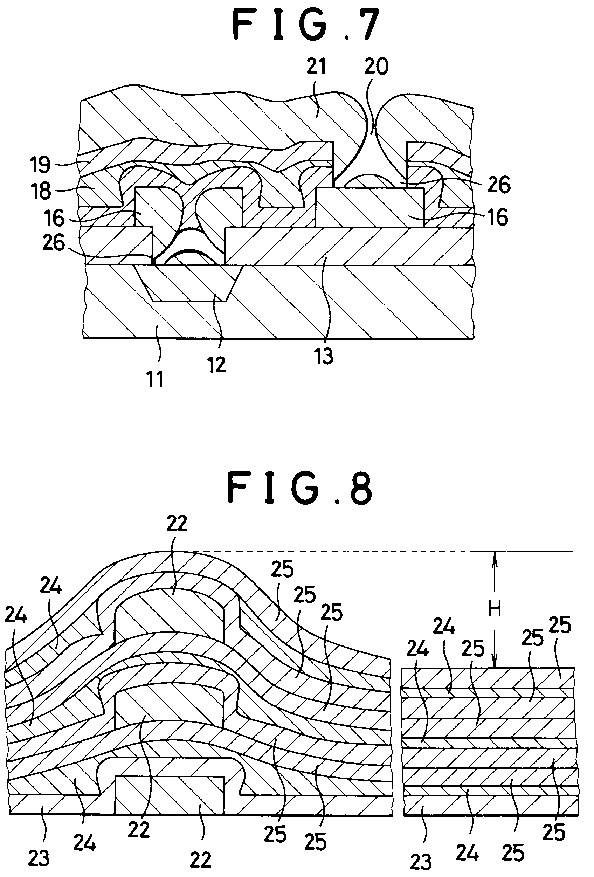

Fig. 8 illustrates a cross section of such a semiconductor device as described above using SOG coating. The Al-Si-Cu lead lines 22 are multi-layered and separated by CVD oxide film 23, SOG 24, and plasma oxide films 25.

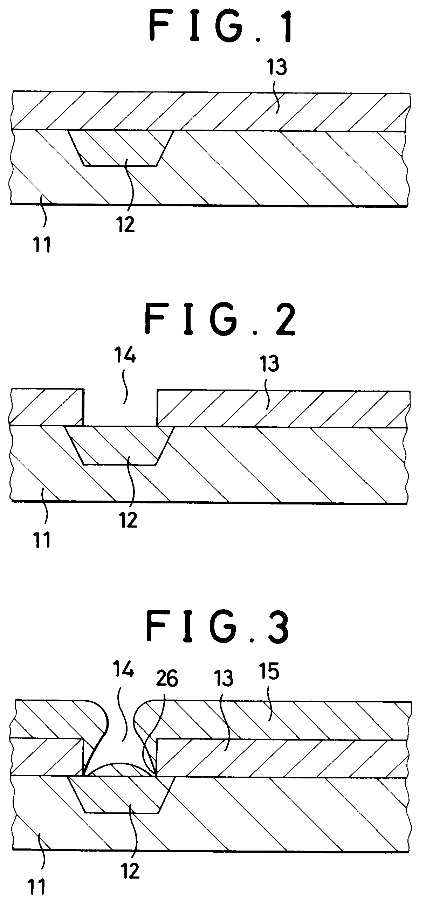

However, such conventional method utilizing SOG coating has a drawback in that, in forming lead lines in the contact holes 14 and the through -holes 20 by sputtering process, a shadowing effect is unavoidable at the corners of the holes where bottom surfaces of these holes 14 and 20 meet their respective side walls. This shadowing effect prevents lead line material from flowing into said corners 26, as shown in Figs. 3 and 7, thereby resulting in imperfect connection between the bottom portions and the corresponding side walls. This is the case particularly when the contact holes 14 and the through-holes have fine structures.

It should be noted that use of SOG 18 for forming flatter inter-layer insulating films adds complexity to a method of manufacturing semiconctor devices. Therefore, the method involving SOG coating between CVD oxide film growth and plasma oxide film growth costs fairly high and production yield is low.

Furthermore, as shown in Fig. 8, the conventional SOG coating results in significant bulging of semiconductor in the region where the semiconductor device contains multiple layers of Al-Si-Cu film lead lines 22 compared with the rest regions since the multi-layered lead lines are separated by CVD oxide films 23, SOG 24, and plasma oxide films 25. This inevitably results in a semiconductor substrate having uneven thickness, with a difference H in height between upper and lower levels of the surface of the substrate. This uneven thickness can be a source of focussing error in lithography, and can lower the reliability of the manufacture.

### SUMMARY OF THE INVENTION

An object of the invention is to provide a method of manufacture of semiconductor device in which fine yet reliable lead lines may be formed at low cost.

Another object of the invention is to provide a method for yielding a multi-layered semiconductor substrate including multi -layered lead lines, yet having substantially constant thickness so that focussing in lithography is simple and accurate, and consequently manufacturing cost will be low.

In order to accomplish these objects, there is provided a method of forming a desired pattern of lead lines on a semiconductor substrate including electrical circuit elements, comprising steps of: (a) forming an insulating film on said semiconductor substrate; (b) forming predetermined arrangement of openings including lead line grooves, contact holes, and through-holes in said insulating film; (c) covering with a lead line material the entire surface of the specimen obtained in step (b); (d) selectively removing said lead line material from the specimen obtained in step (c) except for the region at and near said openings; (e) causing re-flow of said lead line material remaining at and near said openings into corresponding openings to fill said openings.

This method allows the openings for contact holes and through holes filled with the lead line material completely, perfecting electrical contacts therein, so that no connection failure will be incurred during operation of the semiconductor device as observed in conventional ones. Since the lead lines are embedded in insulating inter -layers of oxide, the semiconductor substrate has a flat surface throughout, so that no bulging is involved as in conventional ones. Further, complexity of utilizing SOG is avoided, thereby improving the reliability of the device and manufacturing cost thereof.

Although any conventional heating technique may be used for the re-flow of lead line material use of laser light is preferable.

The insulating film may be formed of BPSG, and the lead line material may be chosen from Al, Cu, Au, and alloys of Al, Cu and Au.

In accordance with the invention there is also provided a method of forming a desired pattern of lead lines on a semiconductor substrate including electrical circuit elements, comprising steps of: (a) forming an insulating film on said semiconductor substrate; (b) forming predetermined arrangement of openings including lead line grooves, contact holes, and through-holes in said insulating film; (c) covering the entire surface of the specimen obtained in step (b) with a metal material having a high melting point and subsequently with a lead line material; (d) selectively removing said metal material and said lead line material from the specimen obtained in step (c) except for the region at and near said openings; (e) causing re -flow of said lead line material remaining at and near said openings into corresponding openings to fill said openings.

In this method, the metal material having high melting point reacts with the surface of the substrate and with oxygen in the oxide film formed thereon to enhance contact between the semiconductor substrate and the lead line material in the contact portions, providing improved reliability of the semiconductor device.

The upper and lower layers of the metal material having high melting point are preferably TiN and Ti, respectively.

### BRIEF DESCRIPTION OF THE DRAWINGS

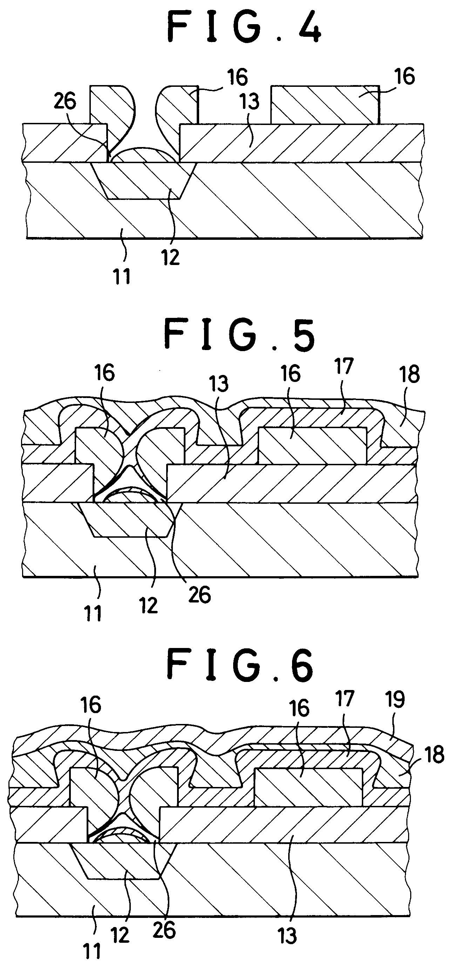

Figs. 1 through 7 are step-wise cross sections of a semiconductor substrate under conventional manufacturing processes.

Fig. 8 is a cross section of a portion of a semiconductor device having multi-layered lead lines manufactured through the steps of Figs. 1 through 7.

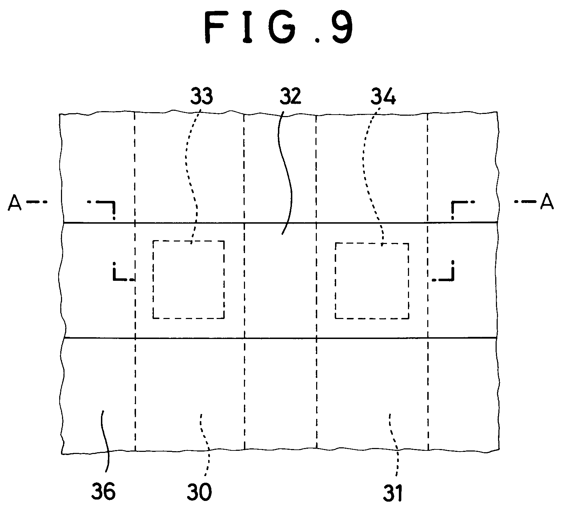

Fig. 9 is a plan view of a semiconductor device manufactured according to the invention.

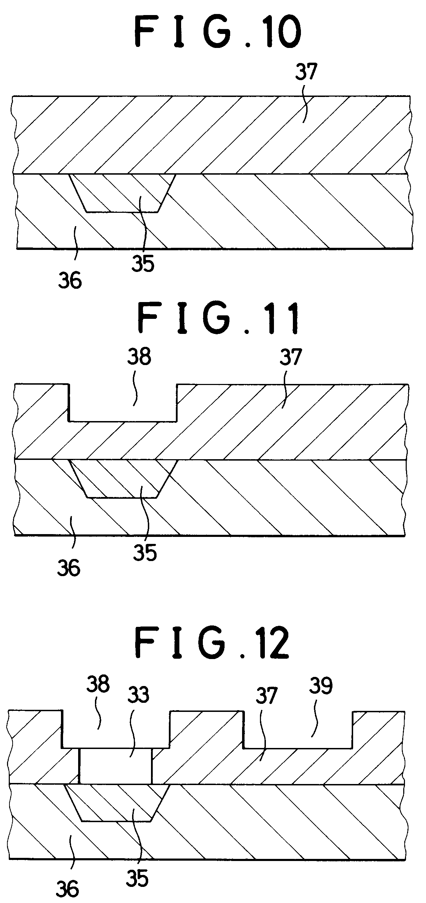

Figs. 10 through 17 are step-wise cross sections of a semiconductor substrate, illustrating a first method of manufacturing semiconductor devices according to the invention, with the cross sections, taken along the line A -A of the semiconductor device shown in Fig. 9.

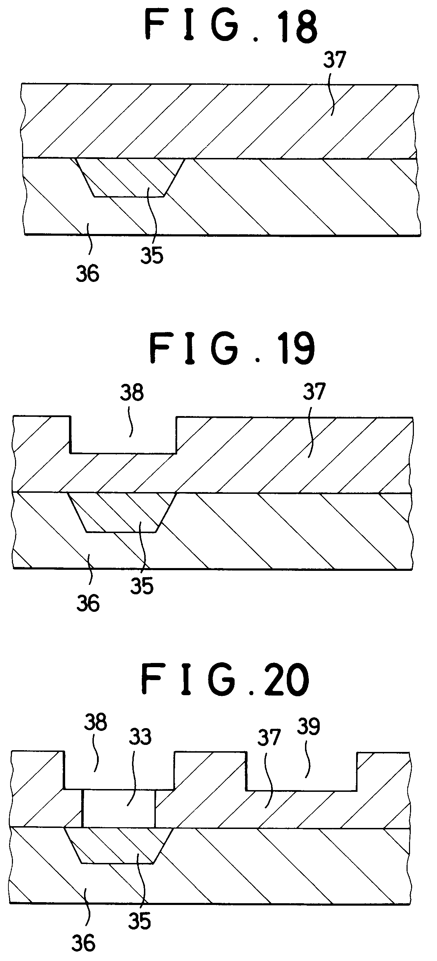

Figs 18 through 25 are step-wise cross sections of a semiconductor substrate, illustrating a second method of manufacturing semiconductor devices according to the invention, with the cross sections, taken along the line A -A of the semiconductor device shown in Fig. 9.

### DESCRIPTION OF THE PREFERRED EMBODIMENTS

The invention is described for a case in which, as shown in Fig. 9, a first-layer lead line pattern including two lead lines 30 and 31 of Al-Si-Cu and a second lead line pattern including a lead line extending in a direction perpendicular to the lead lines 30 and 31 are formed such that a diffusion layer 35 formed in a semiconductor substrate 36 is connected with a first-layer lead line 30 through a contact hole 33 and another first-layer lead line 31 is connected with an upper-layer lead line 32 through a through-hole 34.

A first example of preferred embodiments of the invention is described with reference to Figs. 10 through 17.

First, a substrate 36 having a diffusion layer 35 therein is covered with an insulating film of BPSG (boro-phospho-silicate glass) 37 is formed (to a thickness of about 1.5 µm) (Fig. 10). Next, by means of conventional lithography and etching techniques a lead line groove 38 is formed to a thickness of about 0.75 µm at a prescribed location where contact hole 33 is to be formed (Fig. 11).

Next, after removing the photo-resist used in the preceding process, an inverted pattern of lead lines is used in another lithography and etching processes to simultaneously form a lead line groove 39 approximately 0.75 µm deep in the BPSG 37 simultaneously with the contact hole 33 (Fig. 12).

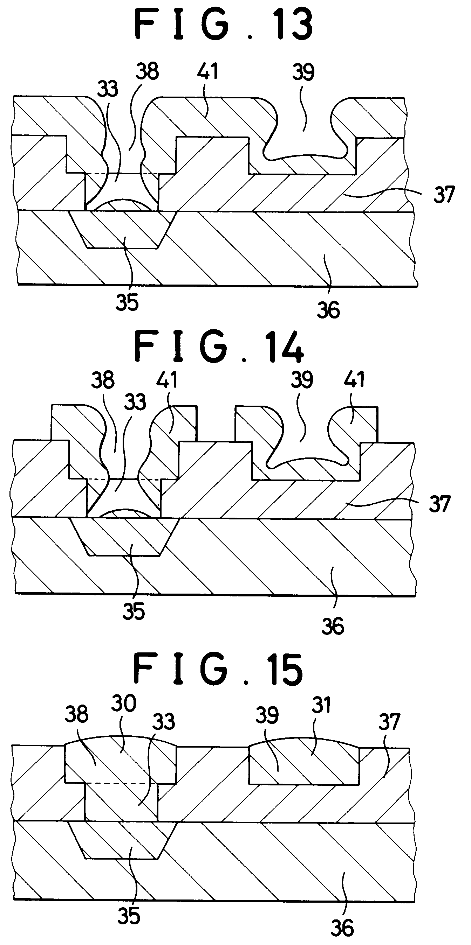

The substrate thus formed is then covered with an Al-Si-Cu film 41 by means of sputtering technique (Fig. 13). The film is about 0.75 µm in thickness. Using conventional lithography and etching techniques the Al-Si-Cu film 41 is selectively removed from the substrate except for the region in the neighborhood of the groove 39, contact hole 33 and the lead line groove 38 (Fig. 14).

Next, remaining Al-Si-Cu 41 is melt by means of XeCl pulse excimer laser so as to flow into the lead line groove 38 and 39 to fill the lead line groove 38 and 39 (such melting of lead line material and filling the holes/grooves will be referred to as re -flow of the material), thereby forming first-layer lead lines 30 and 31 (Fig. 15).

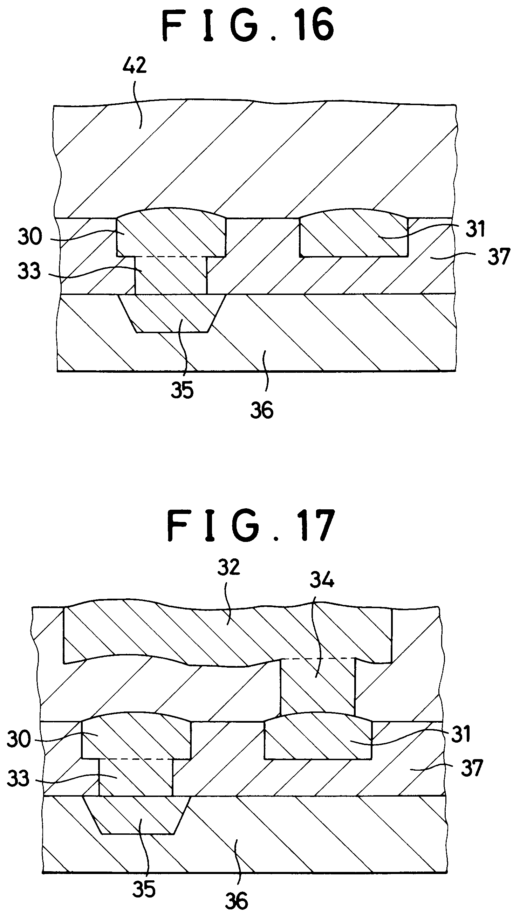

Thereafter, a plasma oxide film 42 is formed to a thickness of about 2 µm (Fig. 16), in which a through-hole 34 for a second -layer lead line 32 (Fig. 17) is formed at a predetermined location in the same manner as described in the preceding processes.

It should be understood that insulating oxide films of phospho-silicate glass (PSG) and non-doped silicate glass (NSG) may be equally used instead of BPSG. It should be also understood that Al or various Al alloys such as AlSi and processes.

It should be understood that insulating oxide films of phospho-silicate glass (PSG) and non-doped silicate glass (NSG) may be equally used instead of BPSG. It should be also understood that Al or various Al alloys such as AlSi and AlCu as well as Cu, Au and alloys of Cu, Au may alternatively used for lead lines instead of Al-Si-Cu.

By the re-flow of the lead line material (Al and Al alloys) caused by laser light, the contact holes 33 and through-holes 34 are filled completely with the lead line material, thereby connecting perfectly the diffusion layer 35 formed in the semiconductor substrate 36 with the first-layer lead line 31 through the through-hole 33, and the first-layer lead line 31 with the second-layer lead line 32 through the through-holes 34. This eliminate possibility of break down of lead lines due to insufficient connection as observed in conventional processes.

According to the invention, since lead lines are formed in grooves in the inter-layers of insulating oxide films, portions of the substrate having multi-layered lead line contacts have substantially the same thickness as the rest portions having less lead line contacts, so that no uneven thickness is introduced in the substrate. No complex SOG deposition is thus needed in processing the substrate. Thus, the invention may provide a method of manufacture of reliable and low- cost semiconductor devices

Referring to Figs. 18 through 25, a second example of preferred embodiments of the invention will be described.

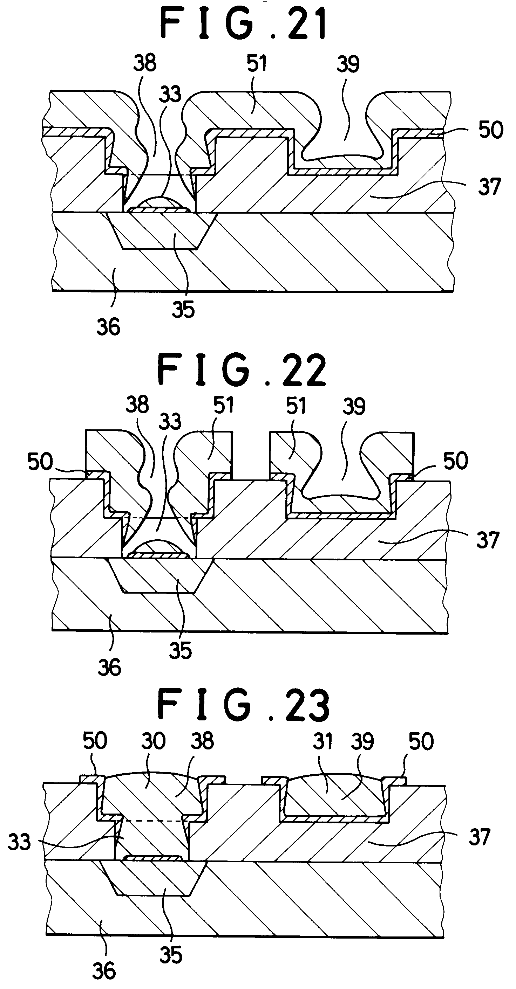

As in the first example described herein, a diffusion layer 35 is formed in a semiconductor substrate 36, over which an insulating film of BPSG (bore-phospho-silicate glass) 37 is formed (to a thickness of about 1.5 µm) (Fig. 18). Next, by means of conventional lithography and etching techniques a lead line groove 38 is formed to a thickness of about 0.75 µm at a prescribed location where a contact hole 33 is to be formed (Fig. 19). Next, after removing the photo-resist used in the preceding process, an inverted pattern of lead lines is used in another lithography and etching processes to simultaneously form a lead line groove 39 approximately 0.75 µm deep in the BPSG 37 (Fig. 20) simultaneously with the contact hole 33 . Up to this point the steps are the same in the first example above.

Thereafter, the substrate is covered first with an upper/lower layers 50 of TiN and Ti, respectively, having about 0.75 µm in total, and second with an Al-Si-Cu film 51 by means of sputtering technique (Fig. 21), which layers 50 and film 51 are then selectively removed by conventional lithography and etching techniques except for the regions at and near the lead line groove 39, the contact hole 33, and the lead line groove 38 (Fig. 22).

Next, using XeCl pulse excimer laser, remaining Al-Si-Cu film 51 is caused to re-flow in the corresponding lead line groove 39, contact hole 33 and the lead line groove 38, to thereby form first-layer lead lines 30 and 31 (Fig. 23).

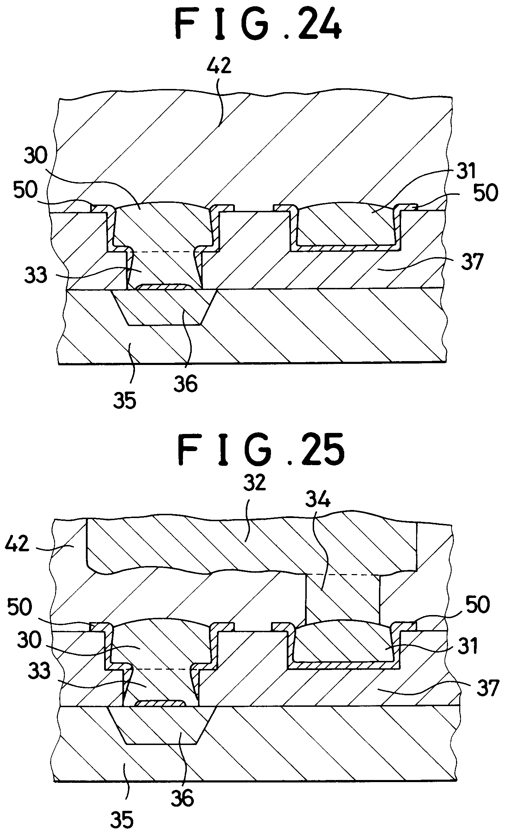

A plasma oxide film 42 having thickness of about 2 µm is formed (Fig. 24), which is subjected to processes similar to those in the preceding steps to form a through-hole 34 for a second-layer lead line 32 (Fig. 25).

It should be noted that the second example described herein may provide, in addition to the same advantages as the first example, further improved reliability of the lead pattern due to the fact that the TiN and Ti layers are formed underneath the Al -Si-Cu lead line material, and that Ti at the bottom of the contact hole 33 and the lead line groove 39 reacts with silicon formed on the surface of the substrate during the preceding steps to enhance electrical contact between the re-flown lead line material and the semiconductor substrate.

As in the first example, the lead line material for the second example is not limited to Al-Si-Cu, and other metals such as Al Cu, Au and alloys of these metals may be alternatively used instead of Al-Si-Cu. It should be understood that various other metal materials such as Ti-W, W, Mo, Cr, Ti-W-N, Mo-Si, Ti-Si, W -Si, having high melting points may be equally used instead of TiN/Ti layers underneath the lead line material.

It should be apparent to those skilled in the art that various modification is possible without departing from the scope of the invention. For example, any known heating technique may be alternatively employed instead of laser light for the purpose of aforementioned re-flow of Al-Si-Cu layer.

## Claims

1. A method of forming a desired pattern of lead lines on a semiconductor substrate including electrical circuit elements, comprising steps of:
(a) forming an insulating film on said semiconductor substrate;
(b) forming predetermined arrangement of openings including lead line grooves, contact holes, and through-holes in said insulating film;
(c) covering with a lead line material the entire surface of the specimen obtained in step (b);
(d) selectively removing said lead line material from the specimen obtained in step (c) except for the region at and near said openings;
(e) causing re-flow of said lead line material remaining at and near said openings into corresponding openings to fill said openings.

2. A method according to claim 1, wherein said re-flow of lead line material is caused by irradiation of laser light.

3. A method according to claim 1, wherein said lead line material is chosen from Al, Cu, Au, and alloys of Al, Cu and Au.

4. A method of forming a desired pattern of lead lines on a semiconductor substrate including electrical circuit elements, comprising steps of:
(a) forming an insulating film on said semiconductor substrate;
(b) forming predetermined arrangement of openings including lead line grooves, contact holes, and through-holes in said insulating film;
(c) covering the entire surface of the specimen obtained in step (b) with a metal material having a high melting point and subsequently with a lead line material;
(d) selectively removing said metal material and said lead line material from the specimen obtained in step (c) except for the region at and near said openings;
(e) causing re-flow of said lead line material remaining at and near said openings into corresponding openings to fill said openings.

5. A method according to claim 4, wherein said re-flow of lead line material is caused by irradiation of laser light.

6. A method according to claim 1, wherein said insulating film is made of BPSG, and said upper and lower layers of the metal material having high melting points are TiN and Ti, respectively.
